# EUROPEAN PATENT APPLICATION

(11) **EP 4 586 764 A1**
(43) Date of publication of application: **16.07.2025**
(21) Application number: 24204387.5
(22) Date of filing: 02.10.2024
(51) Int. Cl.: H10D 30/01, H01L 23/482, H10D 84/00, H10D 30/66

(54) **POWER SEMICONDUCTOR DEVICES**

(30) Priority: 09.01.2024 KR 20240003620
(71) Applicant: Samsung Electronics Co., Ltd, Suwon-si, Gyeonggi-do 16677 (KR)
(72) Inventor: KIM, Taehun, 16677 Suwon-si (KR); KO, Mingu, 16677 Suwon-si (KR); PARK, Gyeongseon, 16677 Suwon-si (KR); KIM, Youngcheol, 16677 Suwon-si (KR); KIM, Jongseob, 16677 Suwon-si (KR); NOH, Jeongin, 16677 Suwon-si (KR)
(74) Representative: Marks & Clerk LLP

(57) **Abstract**

A power semiconductor device includes a substrate having a first conductivity type and being provided with a drift layer having the first conductivity type; a well region having a second conductivity type; source regions having the first conductivity type; gate insulating layers in gate trenches penetrating the source regions and the well region and including a high-x material; gate electrodes on the gate insulating layers and including a metal material; a gate bus line connected to ends of the gate electrodes; a gate pad spaced apart from the gate bus line; a connector electrically connecting the gate bus line to the gate pad and including a material having a resistivity greater than those of the gate bus line and the gate pad; a dielectric layer on the gate electrodes, the gate bus line, the gate pad, and the connector; and a drain electrode on a lower surface of the substrate.

## Description

### BACKGROUND

Example embodiments in the example embodiment relate to a power semiconductor device.

A power semiconductor device may be a semiconductor device operating in a high-voltage and high-current environment and may be used in fields requiring high-power switching, such as power conversion, a power converter, and an inverter. A power semiconductor device may basically require voltage withstanding properties for high voltage, and recently, a high-speed switching operation may also be required. Accordingly, a power semiconductor device using SiC having superior voltage withstanding properties as compared to silicon (Si) has been studied.

### SUMMARY

An example embodiment of the present invention is to provide a power semiconductor device having improved electrical properties.

According to an example embodiment of the present invention, a power semiconductor device includes a substrate having a first conductivity type, the substrate being provided with the drift layer having the first conductivity type on the substrate; a well region having a second conductivity type on the drift layer; source regions having the first conductivity type on the well region; gate insulating layers in gate trenches penetrating the source regions and the well region and extending in a first direction parallel to an upper surface of the substrate, and including a high-x material; gate electrodes on the gate insulating layers in the gate trenches and including a metal material; a gate bus line connected to ends of the gate electrodes and extending in a second direction intersecting the first direction; a gate pad spaced apart from the gate bus line; a connector electrically connecting the gate bus line to the gate pad and having a resistivity greater than those of the gate bus line and the gate pad; a dielectric layer on the gate electrodes, the gate bus line, the gate pad, and the connector; and a drain electrode on a lower surface of the substrate.

According to an example embodiment of the present invention, a power semiconductor device includes a substrate having a first conductivity type, the substrate being provided with the drift layer having the first conductivity type on the substrate; a well region having a second conductivity type on the drift layer; source regions having the first conductivity type on the well region; gate insulating layers in gate trenches penetrating the source regions and the well region and extending in a first direction parallel to an upper surface of the substrate; gate electrodes on the gate insulating layers in the gate trenches; a first gate bus line electrically connected to the gate electrodes; a gate pad spaced apart from the first gate bus line; a connector electrically connecting the first gate bus line to the gate pad; and a drain electrode on a lower surface of the substrate, wherein the gate electrodes include a material having a first resistivity, the first gate bus line and the gate pad having a second resistivity equal to or greater than the first resistivity, and the connector having a third resistivity greater than the second resistivity.

According to an example embodiment of the present invention, a power semiconductor device includes a substrate having a first conductivity type, the substrate being provided with the drift layer having the first conductivity type on the substrate; a well region having a second conductivity type on the drift layer; source regions having the first conductivity type on the well region; gate insulating layers in gate trenches penetrating the source regions and the well region and extending in a first direction parallel to an upper surface of the substrate; gate electrodes on the gate insulating layers in the gate trenches; a gate bus line connected to ends of the gate electrodes and extending in a second direction perpendicular to the first direction; a gate pad spaced apart from the gate bus line; a connector electrically connecting the gate bus line to the gate pad and having a resistivity greater than those of the gate bus line and the gate pad; and a drain electrode on a lower surface of the substrate, wherein each of the gate insulating layers has a first thickness on a bottom surface of each of the gate trenches, and has a second thickness less than the first thickness on a sidewall of each of the gate trenches. According to an example embodiment of the present invention, a substrate having a first conductivity type, the substrate being provided with a drift layer having the first conductivity type on the substrate; a well region having a second conductivity type on the drift layer; source regions having the first conductivity type on the well region; gate insulating layers in gate trenches, the gate insulating layers penetrating the source regions and the well region and extending in a first direction parallel to an upper surface of the substrate, and including a high-x material; gate electrodes on the gate insulating layers in the gate trenches and including a metal material; a first gate bus line connected to first ends of the gate electrodes; a second gate bus line connected to second ends of the gate electrodes, each of the second ends of the gate electrodes being opposite a corresponding one of the first ends of the same gate electrode; both of the gate bus lines extending in a second direction intersecting the first direction; a gate pad spaced apart from the gate bus lines; a connector electrically connecting the gate bus lines to the gate pad, the connector having resistivity greater than those of the gate bus line and the gate pad; a dielectric layer on the gate electrodes, the gate bus line, the gate pad, and the connector; and a drain electrode on a lower surface of the substrate.

The following features may apply to any of the above example embodiments of the present invention.

The substrate, drift layer, well region and source regions may each include semiconductor material (e.g. SiC).

In some embodiments, the first conductivity type may refer to n-type semiconductor, whilst the second conductivity type may refer to p-type semiconductor. In other embodiments, the first conductivity type may refer to p-type semiconductor, whilst the second conductivity type may refer to n-type semiconductor.

In some embodiments, the materials (e.g. the drift region) according to the first conductivity type may each be an n-type semiconductor, whilst the materials (e.g. well region) according to the second conductivity type may each be p-type semiconductor. In other embodiments, the materials according to the first conductivity type may each be a p-type semiconductor, whilst the materials according to the second conductivity type may each be n-type semiconductor.

In some embodiments, the second direction is perpendicular to the first direction.

In some embodiments, the connector includes a doped region of the drift layer, wherein the doped region is of the second conductivity type.

The gate trenches are arranged in parallel with one another.

At least some of the above and other features of the invention are set out in the claims.

### BRIEF DESCRIPTION OF DRAWINGS

The and other aspects, features, and advantages in the example embodiment will be more clearly understood from the following detailed description, taken in combination with the accompanying drawings, in which:
FIG. 1 is a plan diagram illustrating a power semiconductor device according to example embodiments of the present invention;
FIGS. 2A and 2B are cross-sectional views illustrating a power semiconductor device according to example embodiments of the present invention;
FIGS. 3A to 3C are plan views illustrating a power semiconductor device according to example embodiments of the present invention;
FIGS. 4A to 4D are cross-sectional views illustrating a power semiconductor device according to example embodiments of the present invention;
FIG. 5 is a cross-sectional view illustrating a power semiconductor device according to example embodiments of the present invention;
FIGS. 6A and 6B are cross-sectional views illustrating a power semiconductor device according to example embodiments of the present invention; and
FIGS. 7A to 10B are views illustrating processes of a method of manufacturing a power semiconductor device according to example embodiments of the present invention.

### DETAILED DESCRIPTION

Hereinafter, embodiments in the example embodiment will be described as follows with reference to the accompanying drawings. Items described in the singular herein may be provided in plural, as can be seen, for example, in the drawings. Thus, the description of a single item that is provided in plural should be understood to be applicable to the remaining plurality of items unless context indicates otherwise.

Throughout the specification, when a component is described as "including" a particular element or group of elements, it is to be understood that the component is formed of only the element or the group of elements, or the element or group of elements may be combined with additional elements to form the component, unless the context clearly and/or explicitly describes the contrary. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

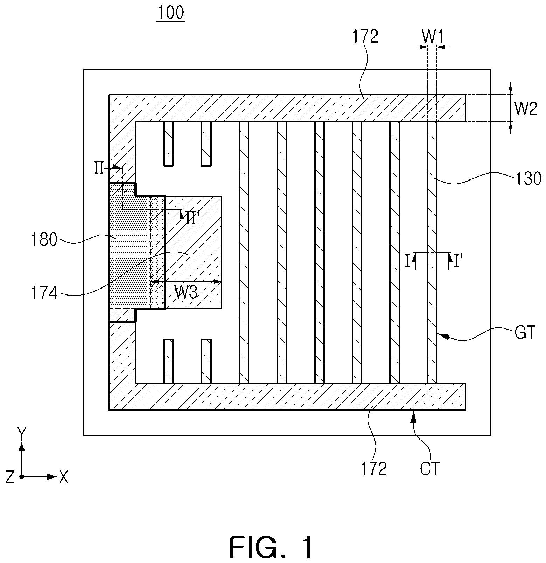

FIG. 1 is a plan diagram illustrating a power semiconductor device according to example embodiments.

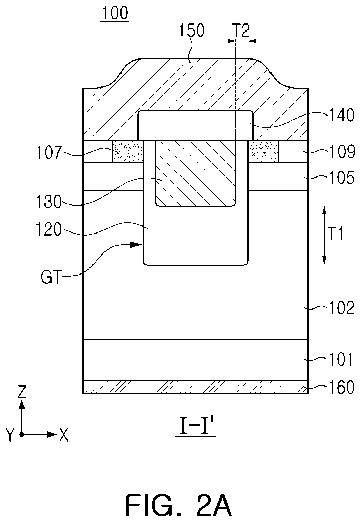

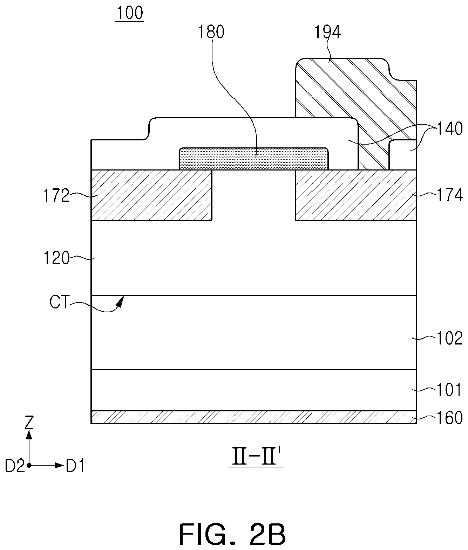

FIGS. 2A and 2B are cross-sectional views illustrating a power semiconductor device according to example embodiments. FIG. 2A is a cross-sectional view taken along line I-I' in FIG. 1, and FIG. 2B is a cross-sectional view taken along line II-II' in FIG. 1. In FIG. 2B, the D1 direction may refer to the Y-direction or the X-direction along the cutting line II-II', and the D2 direction may refer to a direction perpendicular thereto.

Referring to FIGS. 1 to 2B, the power semiconductor device 100 may include a substrate 101, a drift layer 102 on the substrate 101, well regions 105 on the drift layer 102, source regions 107 and well contact regions 109 on the well regions 105, gate insulating layers 120 disposed in gate trenches GT penetrating the source regions 107 and the well regions 105, gate electrodes 130 disposed on the gate insulating layers 120 in the gate trenches GT, gate bus lines 172 connected to ends of gate electrodes 130, gate pad 174 spaced apart from the gate bus lines 172, a connector 180 connecting the gate bus lines 172 to the gate pad 174, dielectric layers 140 covering the gate electrodes 130, source electrode 150 on the dielectric layers 140, a pad metal layer 194 on the gate pad 174, and a drain electrode 160 on a lower surface of the substrate 101. The power semiconductor device may be a semiconductor chip.

The substrate 101 may have an upper surface extending in the X-direction and the Y-direction. The substrate 101 may include a semiconductor material, for example, silicon carbide (SiC). However, in some example embodiments, the substrate 101 may include a group IV semiconductor material such as silicon (Si) or Germanium (Ge), or a compound semiconductor material such as silicon-germanium (SiGe), gallium arsenide (GaAs), indium arsenide (InAs), or indium phosphide (InP).

The substrate 101 may be provided as a bulk wafer or an epitaxial layer. The substrate 101 may include first conductivity-type impurities (charge carrier dopants) and may thus have a first conductivity type. In some example embodiments, the first conductivity type may be, for example, N-type conductivity, and the first conductivity-type impurities may be N-type impurities, for example, nitrogen (N) and/or phosphorus (P). In some example embodiments, the first conductivity type may be, for example, P-type conductivity, and the first conductivity-type impurities may be, for example, P-type conductivity-type impurities such as aluminum (Al).

The drift layer 102 may be disposed on the substrate 101. The drift layer 102 may include a semiconductor material, for example, SiC. The drift layer 102 may be configured as an epitaxial layer grown on the substrate 101. The drift layer 102 may include first conductivity-type impurities and may thus have the first conductivity type. A concentration of the first conductivity-type impurities of the drift layer 102 may be lower than a concentration of the first conductivity-type impurities of the substrate 101. In example embodiments, the first conductivity-type impurities in the substrate 101 and the drift layer 102 may be the same or different elements (i.e., same or different chemical elements).

In semiconductor technology, if a semiconductor (e.g., silicon) material contains both p-type and n-type impurities, the conductivity-type of the semiconductor will be determined by which type of impurities is in greater concentration. Therefore, if a semiconductor material has both p-type and n-type impurities, the net conductivity type will be determined by the dominant impurity concentration. As used herein, a "first conductivity-type of an element" denotes that the dominant impurities is (or are) a first conductivity-type impurity, and a "concentration of the first conductivity-type of the element" (or a "doping concentration") refers to the net concentration of the dominant impurities (i.e., first conductivity-type impurities)".

The well regions 105 may be disposed at a predetermined depth from an upper surface of the drift layer 102 and may be spaced apart from each other by the gate trenches GT in a horizontal direction, such as the X-direction. The well region 105 may include a semiconductor material, for example, SiC. The well region 105 may have a second conductivity type and may include second conductivity-type impurities. The second conductivity type may be, for example, P-type conductivity, and the second conductivity-type impurities may be, for example, P-type conductivity-type impurities such as aluminum (Al). In some example embodiments, the well region 105 may include a plurality of regions having different doping concentrations.

The source regions 107 may be disposed at a predetermined depth from upper surfaces of the well regions 105. A thickness of the source region 107 may be smaller than a thickness of the well region 105. The source region 107 may include a semiconductor material, for example, SiC. The source region 107 may have the first conductivity type and may include the first conductivity-type impurities described above. A concentration of the first conductivity-type impurities of the source region 107 may be higher than a concentration of the first conductivity-type impurities of the drift layer 102, but the invention is not limited thereto.

The well contact regions 109 may be disposed on the well regions 105 and on one side of the source regions 107. The well contact region 109 may be disposed between the well region 105 and the source electrode 150, such that a voltage from the source electrode 150 may be applied to the well region 105. The well contact region 109 may include a semiconductor material, for example, SiC. The well contact region 109 may have the second conductivity type and may include the second conductivity-type impurities described above. A concentration of the second conductivity-type impurities in the well contact region 109 may be higher than a concentration of the second conductivity-type impurities in the well region 105.

Gate trenches GT may penetrate the source regions 107 and the well regions 105 from upper surfaces of the source regions 107 and may extend into the drift layer 102. The gate trenches GT may be spaced apart from each other in the X-direction. The gate trench GT may completely penetrate the well region 105, and an end of the gate trench GT may be disposed in the drift layer 102. However, a length of the gate trench GT extending into the drift layer 102 may be varied in example embodiments. A gate insulating layer 120 and a gate electrode 130 may be disposed in the gate trench GT.

The gate insulating layers 120 may be disposed in the gate trenches GT, respectively. The gate insulating layer 120 may extend along a bottom surface and sidewalls of the gate trench GT and may cover a side surface and a lower surface of the gate electrode 130. The gate insulating layer 120 may be disposed between the source region 107 and the gate electrode 130, between the well region 105 and the gate electrode 130, and between the drift layer 102 and the gate electrode 130.

The gate insulating layer 120 may include a high-κ material. The high-κ material may refer to a dielectric material having a dielectric constant higher than that of silicon dioxide (SiO₂). The high-κ material may be one of, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

The gate insulating layer 120 may have a varying thickness. As illustrated in FIG. 2A, the gate insulating layer 120 may have a first thickness T1 on a bottom surface of the gate trench GT in the Y-direction and a second thickness T2 on a sidewall of the gate trench GT in the X-direction. The second thickness T2 may be smaller than the first thickness T1.

The gate electrodes 130 may be disposed in the gate trenches GT, respectively. The gate electrodes 130 may extend in the Y-direction, and may be spaced apart from each other in the X-direction. The gate electrode 130 may be disposed on the gate insulating layer 120 in the gate trench GT. The gate electrode 130 may overlap the drift layer 102, the well region 105, and the source region 107 in a horizontal direction, such as the X-direction. A lower surface of the gate electrode 130 may be disposed in the drift layer 102. For example, the lower surface of the gate electrode 130 may be lower than an upper surface of the drift layer 102 in a vertical direction (i.e., Z-direction), and may be higher than a lower surface of the drift layer 102. In some example embodiments, a lower surface of the gate electrode 130 may be disposed in the well region 105. For example, the lower surface of the gate electrode 130 may be lower than an upper surface of the well region 105, and may be higher than a lower surface of the well region 105. Accordingly, the lower surface of the gate electrode 130 may be disposed at the same level as a level of the lower surface of the well region 105, or may be disposed at a level lower than the level of the lower surface of the well region 105. As used herein, a "lever" refers to a "height level, and any comparison (i.e., same, lower, higher, etc.) between two or more levels is with respect to the vertical direction (i.e., Z-direction).

An upper surface of the gate electrode 130 may be disposed at the same level as a level of an upper surface of the source region 107, or may be disposed at a level lower than the level of the upper surface of the source region 107. In some example embodiments, a level of the upper surface of the gate electrode 130 may be disposed higher than the level of the upper surface of the source region 107.

The gate electrode 130 may include a conductive material, for example, a metal material. The gate electrode 130 may include, at least one of titanium nitride (TiN), titanium (Ti), titanium carbide (TiC), tantalum nitride (TaN), tungsten nitride (WN), aluminum (Al), tungsten (W), and molybdenum (Mo). In example embodiments, the gate electrode 130 may be a multilayer of two or more materials.

In the power semiconductor device 100, the gate electrode 130 may include a metal material. The gate insulating layer 120 may include a high-κ material. Accordingly, channel mobility may increase as capacitance increases in a direction of a sidewall of the gate trench GT. The gate insulating layer 120 may have a relatively great thickness on a bottom surface of the gate trench GT compared to the thickness on a side surface of the gate trench GT. Accordingly, though capacitance increases, a switching speed may be adjusted to prevent excessive increase. An excessively high switching speed of a power semiconductor device may undesirably induce a ringing phenomenon in a system including the power semiconductor device.

The gate bus lines 172 and the gate pad 174 may be electrically connected to the gate electrodes 130, and may be configured as a gate interconnection structure for connecting the gate electrodes 130 to an external circuit. Each of the gate bus lines 172 may have a first portion, a second portion and a bending portion. The first portion of the gate bus line 172 may be connected to ends of the gate electrodes 130 and may extend in a direction intersecting an extension direction of the gate electrodes 130 (e.g., the X-direction). Each of the first portions of the gate bus lines 172 may end up being connected to the bending portion. The second portion of the gate bus line 172 may extend in the Y-direction, and may end up being connected to the bending portion. A plurality of the gate bus lines 172 may be disposed. For example, two gate bus lines 172 may be disposed, and may be electrically connected at one end to each other. Other ends of the two gate bus lines 172 may be electrically and/or physically connected to corresponding ones of the ends of the gate electrodes 130, respectively.

The gate pad 174 may be disposed adjacent to ends of the gate bus lines 172 and may be spaced apart from the gate bus lines 172. The gate pad 174 may be electrically connected to the pad metal layer 194, which is disposed on an upper portion. The gate pad 174 may receive an electrical signal through the pad metal layer 194.

The gate bus lines 172 may be disposed in a symmetrical form in the Y-direction, with respect to the gate pad 174. A second width W2 of the gate bus lines 172 in the Y-direction may be greater than a first width W1 of the gate electrode 130 in the X-direction. A third width W3 of gate pad 174 in the X-direction may be greater than the second width W2, and the width in the Y-direction may also be greater than the second width W2. The gate pad 174 may have a quadrangular shape, a circular shape, an elliptical shape in a plan view according to example embodiments.

The gate bus lines 172 and the gate pad 174 may be disposed in the connection trench CT. The connection trench CT may extend into the drift layer 102 from an upper surface of the drift layer 102, though not shown in the drawings. The connection trench CT may be formed together with the gate trenches GT and may be disposed at the same level as a level of the gate trenches GT. The gate insulating layer 120 may be disposed in the connection trench CT, and the gate bus lines 172 and the gate pad 174 may be disposed on the gate insulating layer 120. The gate insulating layer 120 in the connection trench CT may be simply formed together with the gate insulating layers 120 in the gate trenches GT. The gate insulating layer 120 in the connection trench CT and in the gate trenches GT may be formed simultaneously by a series of steps of a semiconductor manufacturing process. Because the gate insulating layer 120 in the connection trench CT may not substantially function as a gate dielectric of a transistor, the portion of the gate insulating layer 120 in the connection trench CT may separately be referred to as a trench insulating layer. Upper surfaces of the gate bus lines 172 and the gate pad 174 may be disposed on substantially the same level as a level of upper surfaces of the gate electrodes 130, upper surfaces of the source regions 107, and an uppermost surface of the drift layer 102.

The gate bus lines 172 and the gate pad 174 may include the same material, for example, a metal material. The gate bus lines 172 and the gate pad 174 may include the same material as that of the gate electrode 130. The gate bus lines 172 and the gate pad 174 may include, for example, at least one of titanium nitride (TiN), titanium (Ti), titanium carbide (TiC), tantalum nitride (TaN), tungsten nitride (WN), aluminum (Al), tungsten (W), and molybdenum (Mo). However, in some example embodiments, the gate bus lines 172 and the gate pad 174 may have different resistivity from that of the gate electrode 130. In this case, the gate bus lines 172 and the gate pad 174 may have resistivity the same as or greater than that of the gate electrode 130. For example, the gate bus lines 172 and the gate pad 174 may include a material different from that of the gate electrode 130. In this case, the gate bus lines 172 and the gate pad 174 may include a material having resistivity the same as or greater than that of the gate electrode 130. As used herein, when "an element has a resistivity," it will be understood that the "resistivity" refers to the resistivity of the entire components of the element, unless context indicates otherwise. For example, if an element includes multiple components (e.g., materials, layers, etc.), when it is stated that "an element has a resistivity", this resistivity refers to the combined resistivity of all components (e.g., all layers and materials comprising the element).

In some example embodiments, the gate bus lines 172 may include a material different from that of the gate pad 174 or may be formed of the same material, for example, a metal material. In this case, the gate pad 174 may include a material having resistivity greater than that of the gate bus lines 172.

The connector 180 may connect the gate bus lines 172 to the gate pad 174. As illustrated in FIG. 1, the connector 180 may be disposed on the gate bus lines 172 and the gate pad 174 such that a portion thereof may overlap each of the gate bus lines 172 and the gate pad 174 in the Z-direction. In the example embodiment, the connector 180 may be disposed as a single connector. The connector 180 may be disposed in a symmetrical form in the Y-direction with respect to the gate pad 174. The connector 180 may have a central region having a region overlapping the gate pad 174, and regions protruding from the central region toward each of the gate bus lines 172. However, in example embodiments, the shape of the connector 180 in a plan view may be varied.

The connector 180 may be in contact with upper surfaces of the gate bus lines 172 and upper surfaces of the gate pad 174. A lower surface of the connector 180 may be in contact with the gate insulating layer 120 in the connection trench CT. A lower surface of the connector 180 may be disposed at substantially the same level as a level of upper surfaces of the source regions 107 and/or upper surfaces of the gate electrodes 130. An upper surface of the connector 180 may be disposed on a level higher than a level of the upper surfaces of the source regions 107 and the upper surfaces of the gate electrodes 130.

The connector 180 may include a conductive material, for example, a semiconductor material or a metal material. The connector 180 may include a material different from those of the gate bus lines 172 and the gate pad 174. The connector 180 may include a material different from that of the gate electrode 130. The connector 180 may include a material having resistivity greater than that (or those) of the gate bus lines 172 and the gate pad 174. The connector 180 may include a material having resistivity greater than that of the gate electrode 130. For example, the connector 180 may include doped polycrystalline silicon. Alternatively, the connector 180 may include a metal material having resistivity greater than that (or those) of a metal material (or materials) of the gate bus lines 172 and the gate pad 174.

When a switching speed of a SiC-based power semiconductor device is typically higher than that of a Si-based power semiconductor device. The ringing phenomenon described above may occur as a switching speed increases. According to embodiments of the invention, a switching speed of a power semiconductor device 100 may be adjusted to be reduced by utilizing the connector 180 of relatively high resistance disposed between the gate bus lines 172 and the gate pad 174, such that suitability for a commercialized package and module may be improved and the ringing phenomenon may be prevented. By utilizing the connector 180 of relatively high resistance, an overall resistance of the gate interconnection structure, which connects the gate electrodes 130 to an external circuit, may be adjusted to be increased.

The dielectric layers 140 may cover the gate electrodes 130, the gate bus lines 172, and the gate pad 174, and may be disposed to expose a portion of each of the source regions 107 and the well contact regions 109. The dielectric layer 140 may also expose a portion of the gate pad 174. The dielectric layer 140 may include an insulating material and may include at least one of silicon oxide, silicon nitride, and silicon oxynitride. In some example embodiments, the dielectric layer 140 may include a high-κ material, similarly to the gate insulating layer 120.

The source electrode 150 may be disposed on the dielectric layer 140 and may be electrically connected to the source regions 107 and the well contact regions 109. The source electrode 150 may include a metal material, for example, at least one of nickel (Ni), aluminum (Al), titanium (Ti), silver (Ag), vanadium (V), tungsten (W), cobalt (Co), molybdenum (Mo), copper (Cu), and ruthenium (Ru). The source electrode 150 may include a metal-semiconductor compound layer disposed on an interfacial surface in contact with the source regions 107 and the well contact regions 109. The metal-semiconductor compound layer may include a metal element and a semiconductor element, for example, at least one of TiSi, CoSi, MoSi, LaSi, NiSi, TaSi, or Wsi.

The pad metal layer 194 may be disposed on the gate pad 174 and the dielectric layer 140 and may be electrically connected to the gate pad 174 exposed by the dielectric layer 140. For example, the pad metal layer 194 may be configured as a wire bonding region in a package or module process. The pad metal layer 194 may include a metal material, for example, at least one of copper (Cu), aluminum (Al), silver (Ag), nickel (Ni), titanium (Ti), vanadium (V), tungsten (W), cobalt (Co), molybdenum (Mo), and ruthenium (Ru).

The drain electrode 160 may be disposed on a lower surface of the substrate 101 and may be electrically connected to the substrate 101. The drain electrode 160 may include a metal material, for example, at least one of nickel (Ni), aluminum (Al), titanium (Ti), silver (Ag), vanadium (V), and tungsten (W). In some example embodiments, the drain electrode 160 may also include a metal-semiconductor compound layer, similarly to the source electrode 150.

The power semiconductor device 100 may be configured as a metal oxide semiconductor field effect transistor (MOSFET) in example embodiments, but the structure of the gate bus lines 172, the gate pad 174, and/or the connector 180 in the example embodiments may also be applied to a super junction MOSFET, a double trench MOSFET, an insulated gate bipolar transistor (IGBT) device, etc.

In the description of the example embodiments below, repeated descriptions of the same or similar elements discussed above with reference to FIGS. 1 to 2B will not be provided.

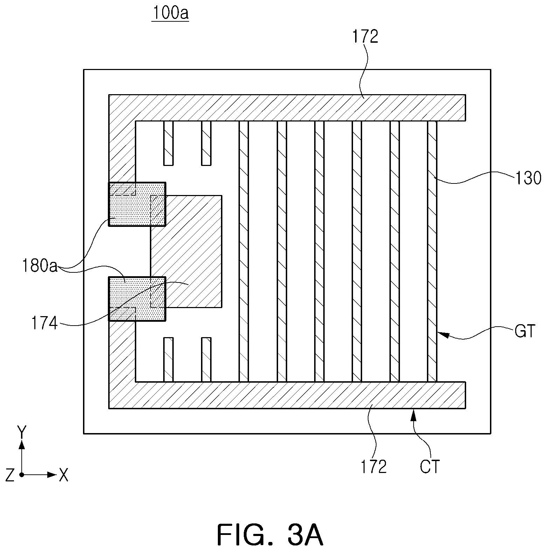

FIGS. 3A to 3C are plan views illustrating a power semiconductor device according to example embodiments.

Referring to FIG. 3A, a power semiconductor device 100a may include a plurality of connectors 180a. The number of the connectors 180a may correspond to the number of gate bus lines 172. For example, two connectors 180a and two gate bus lines 172 may be provided. The connectors 180a may be spaced apart from each other. The connectors 180a may be disposed to connect each of the gate bus lines 172 to a gate pad 174. The shape of connectors 180a in the plan view may be varied or modified, provided that the overlap between the connectors 180a and each of the gate bus line 172 and the gate pad 174 is maintained.

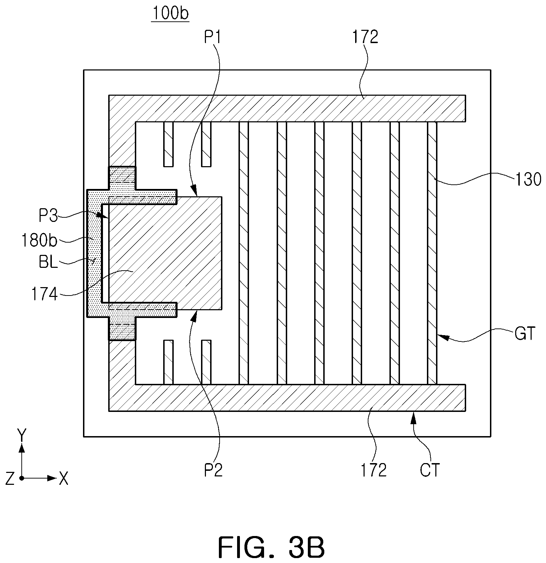

Referring to FIG. 3B, in a power semiconductor device 100b, a connector 180b may include a bypass region BL. Specifically, the connector 180b may connect one of the gate bus lines 172 to a first side P1 of an adjacent gate pad 174. From the first side P1, the connector 180b may bypass the gate pad 174, and may extend in the Y-direction along third side P3 of the gate pad 174. From the bypass region BL, the connector 180b may further extend and may connect another of the gate bus lines 172 to a second side P2 of the adjacent gate pad 174. The bypass region BL may be spaced apart from the gate pad 174 and may extend along an edge of the gate pad 174. The connector 180b may have protruding regions toward the gate bus lines 172.

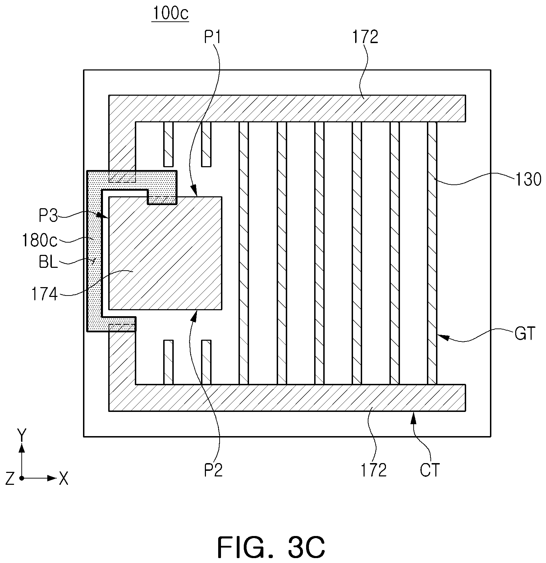

In some example embodiments, the connector 180b may have an asymmetric shape in the Y-direction with respect to the gate pad 174. In this case, the connector 180b may not be directly (i.e., physically or mechanically) connected to the second side P2 of the gate pad 174. Referring to FIG. 3C, in a power semiconductor device 100c, a connector 180c may have an asymmetric shape in the Y-direction with respect to the gate pad 174. Specifically, the connector 180c may connect a gate bus line 172 to a first side P1 of the adjacent gate pad 174, may detour along a third side P3 side of the gate pad 174 through the bypass region BL and may be connected to another gate bus line 172. The connector 180c may not be directly connected to the second side P2 of the gate pad 174. Also, differently from the example embodiment in FIG. 3B, the connector 180c may have a region protruding toward the gate pad 174 rather than a region protruding toward the gate bus line 172.

As described above, in example embodiments, the shape of the connectors 180a, 180b, and 180c and the number of the connectors 180a, 180b, and 180c on a plane may be varied as long as the overlap between the connectors 180a, 180b, and 180c and each of the gate bus line 172 and the gate pad 174 is maintained.

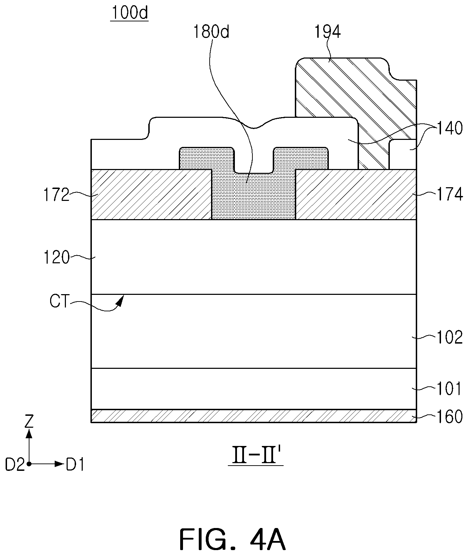

FIGS. 4A to 4D are cross-sectional views illustrating a power semiconductor device according to example embodiments, illustrating variations of the region corresponding to FIG. 2B.

Referring to FIG. 4A, in a power semiconductor device 100d, a portion of a connector 180d may extend into a connection trench CT. The connector 180d may extend from an upper surface of a gate bus line 172 and an upper surface of a gate pad 174 to a region between the gate bus line 172 and the gate pad 174, and may be in contact with a side surface of the gate bus line 172 and a side surface of the gate pad 174. A lower surface of the connector 180d may be coplanar with a lower surface of the gate bus line 172 and a lower surface of the gate pad 174. Terms such as "same," "equal," "planar," "coplanar," "parallel," and "perpendicular," as used herein encompass identicality or near identicality and includ variations that may occur, for example, due to manufacturing processes. The term "substantially" may be used herein to emphasize this meaning, unless the context or other statements indicate otherwise. However, in some example embodiments, the lower surface of connector 180d may be disposed at a level higher or lower than a level of the lower surface of the gate bus line 172 and the lower surface of the gate pad 174. The lower surface of connector 180d may be disposed at a level lower than a level of upper surfaces of the source regions 107 in FIG. 2A, and an upper surface may be disposed at a level higher than a level of upper surfaces of the source regions 107.

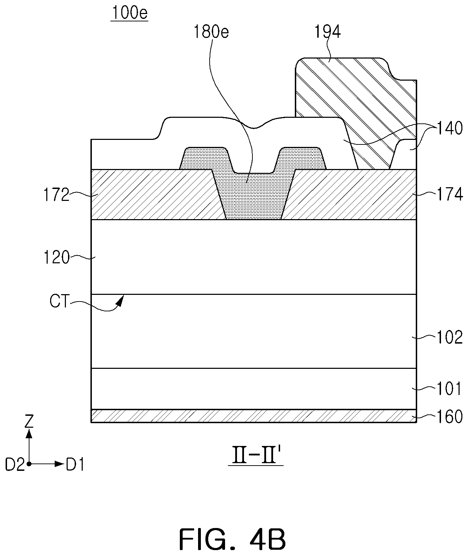

Referring to FIG. 4B, in a power semiconductor device 100e, a portion of a connector 180e may extend into a connection trench CT as in the example embodiment in FIG. 4A. However, in the example embodiment, gate bus lines 172, a gate pad 174, and the connector 180e may have inclined side surfaces. Whether the side surface of the connector 180e is inclined and the degree of inclination may be determined in consideration of the shape, the size, and process difficulty of the connector 180e.

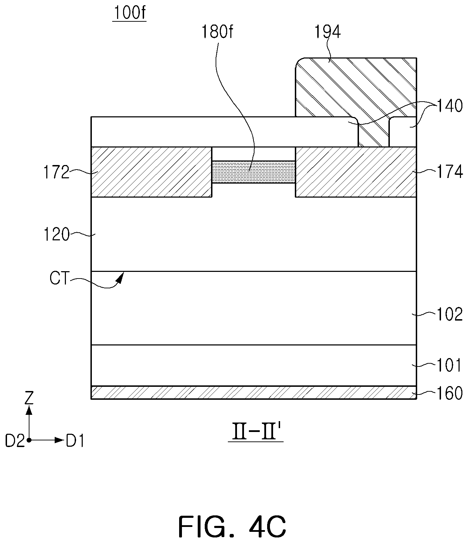

Referring to FIG. 4C, in a power semiconductor device 100f, a connector 180f may connect a gate bus line 172 to a gate pad 174 in a connection trench CT. Specifically, the connector 180f may be buried in a gate insulating layer 120 in the connection trench CT, and an upper surface and a lower surface thereof may be covered with the gate insulating layer 120. The connector 180f may be in contact with a side surface of the gate bus line 172 and a side surface of the gate pad 174. An upper surface and a lower surface of the connector 180f may be disposed at a level lower than a level of upper surfaces of the source regions 107 (shown in FIG. 2A).

In example embodiments, a depth at which the connector 180f is disposed may be varied. For example, in some example embodiments, the connector 180f may be disposed at a relatively shallow depth, such that the upper surface of the connector 180f may be covered and in contact with a dielectric layer 140 rather than the gate insulating layer 120.

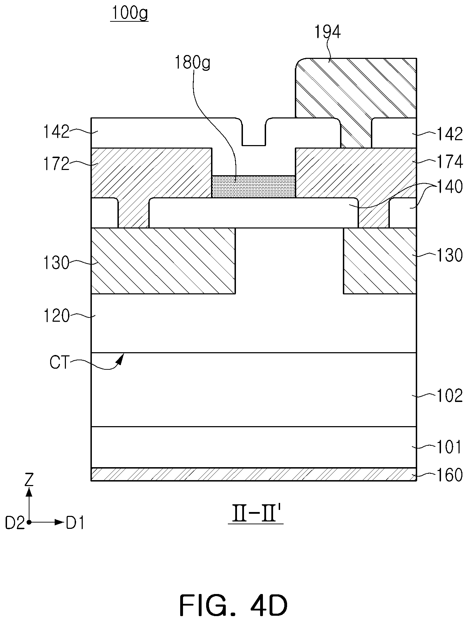

Referring to FIG. 4D, in a power semiconductor device 100g, a gate bus line 172 and a gate pad 174 may be disposed on gate electrodes 130. In the example embodiment, the gate electrodes 130 may be further disposed to extend in the Y-direction below the gate bus line 172 and the gate pad 174. The gate bus line 172 and the gate pad 174 may be disposed such that a portion thereof may respectively overlap the gate electrodes 130 in the Z-direction. The gate bus line 172 and the gate pad 174 may be disposed on the dielectric layer 140 and may be vertically connected to the gate electrodes 130 in at least one region of the gate electrodes 130. In some example embodiments, only the gate bus line 172 may be vertically connected to the gate electrode 130.

A connector 180g may be disposed to connect the gate bus line 172 to the gate pad 174 on the dielectric layer 140. The connector 180g may connect a side surface of the gate bus line 172 to a side surface of the gate pad 174. An interlayer insulating layer 142 may be further disposed on the gate bus line 172, the gate pad 174, and the connector 180g, and a pad metal layer 194 may be disposed on an interlayer insulating layer 142. However, in some example embodiments, a pad metal layer 194 may not be provided.

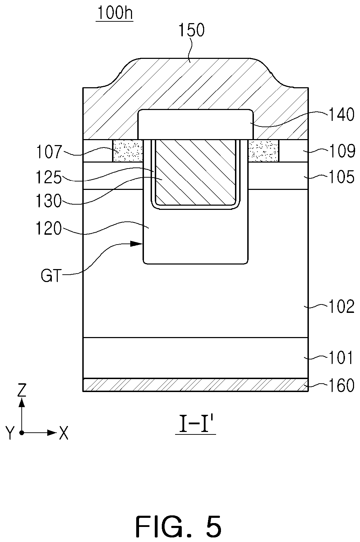

FIG. 5 is a cross-sectional view illustrating a power semiconductor device according to example embodiments, illustrating a variation of the region corresponding to FIG. 2A.

Referring to FIG. 5, a power semiconductor device 100h may further include an intermediate insulating layer 125 disposed between a gate electrode 130 and a gate insulating layer 120. The intermediate insulating layer 125 may cover side surfaces and a lower surface of the gate electrode 130 in a gate trench GT. An intermediate insulating layer 125 may prevent oxidation of the gate insulating layer 120 during the process of manufacturing the power semiconductor device 100h. The intermediate insulating layer 125 may function as a gate insulating layer of a transistor together with the gate insulating layer 120. The intermediate insulating layer 125 may include at least one of an insulating material, for example, silicon oxide, silicon nitride, and silicon oxynitride.

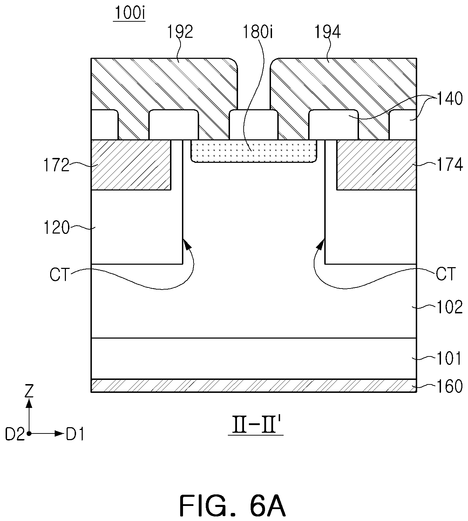

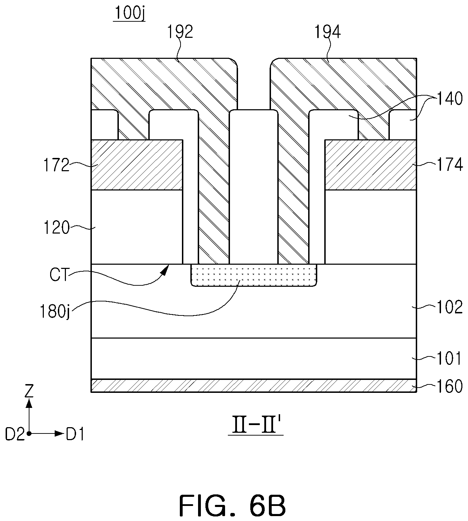

FIGS. 6A and 6B are cross-sectional views illustrating a power semiconductor device according to example embodiments, illustrating variation of the region corresponding to FIG. 2B.

Referring to FIG. 6A, in a power semiconductor device 100i, a connector 180i may be a doped region in a drift layer 102a, and extending from an upper surface of the drift layer 102. The power semiconductor device 100i may further include a bus metal layer 192.

In the example embodiment, a gate bus line 172 and a gate pad 174 may be disposed in connection trenches CT spaced apart from each other, respectively. In the drift layer 102 between the connection trenches CT, the connector 180i may extend a predetermined depth from an upper surface thereof. The connector 180i may be configured as a doped region having the same second conductivity type as that of the well region 105 (see FIG. 2A) and may include second conductivity-type impurities. A concentration of the second conductivity-type impurities in the connector 180i may be the same as those of the well region 105 or the well contact region 109 (see FIG. 2A), but the invention is not limited thereto. Even in the example embodiment, resistivity of the connector 180i may be greater than resistivity of the gate bus line 172 and the gate pad 174.

The bus metal layer 192 and a pad metal layer 194 may be disposed on the dielectric layers 140 to overlap the gate bus line 172 and the gate pad 174 in the Z-direction, respectively. The bus metal layer 192 may be connected to the gate bus line 172 and the connector 180i, and the pad metal layer 194 may be connected to the gate pad 174 and the connector 180i. Accordingly, the gate bus line 172 may be electrically connected to the gate pad 174 through the bus metal layer 192, the connector 180h, and the pad metal layer 194, in that order.

Referring to FIG. 6B, in a power semiconductor device 100j, a connector 180j may have a shape of a doped region as in the example embodiment in FIG. 6A, but the level at which the connector 180j is disposed may be different. In the example embodiment, a gate bus line 172 and a gate pad 174 may be disposed in a connection trench CT, and a dielectric layer 140 may fill a portion of the connection trench CT between the gate bus line 172 and the gate pad 174. In some example embodiments, a region between the gate bus line 172 and the gate pad 174 may be filled with the gate insulating layer 120. The connector 180j may be disposed at a predetermined depth from an upper surface of the drift layer 102, which is between the connection trench CT. As for other configurations, the description of the connector 180i in FIG. 6A may be applied.

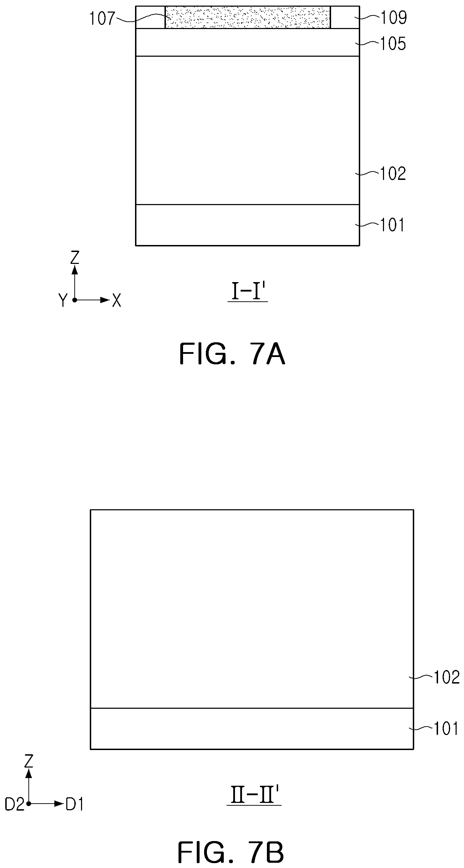

FIGS. 7A to 10B are views illustrating processes of a method of manufacturing a power semiconductor device according to example embodiments, and illustrating an example embodiment of a method of manufacturing the power semiconductor device in FIGS. 2A and 2B.

Referring to FIGS. 7A and 7B, a drift layer 102 may be formed on a substrate 101, and a well region 105, a source region 107, and well contact regions 109 may be formed.

The substrate 101 may be provided as, for example, a SiC wafer. The drift layer 102 may be formed by epitaxial growth from the substrate 101. The drift layer 102 may be formed to include first conductivity-type impurities.

The well region 105, the source region 107, and the well contact regions 109 may be sequentially formed in the drift layer 102 by an ion implantation process. Second conductivity-type impurities may be implanted in the well regions 105 and the well contact regions 109. First conductivity-type impurities may be implanted in the source regions 107. After the ion implantation process, an annealing process may be performed at a high temperature, for example, about 1600°C to about 1800°C.

In the region corresponding to FIG. 7B, the well region 105, the source region 107, and the well contact region 109 may not be formed. Alternatively, in some example embodiments, in the region corresponding to FIG. 7B, at least one of the well region 105, the source region 107, and the well contact region 109 may be formed, and may be removed subsequently.

In other example embodiments, the drift layer 102 may be formed in (as part of) the substrate 101 in order by an ion implantation process. Impurities may be implanted in the substrate 101. After the ion implantation process, an annealing process may be performed. Accordingly, as used herein, the term "substrate" should not be interpreted as requiring materially distinctiveness from the drift layer. The substrate and drift layer may have material continuity or may not. Reference to the substrate being provided with the drift layer is intended to encompass these alternatives.

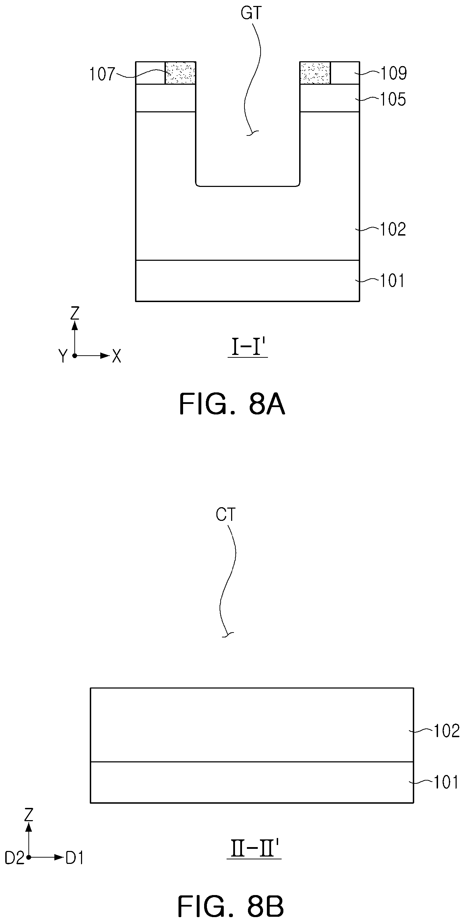

Referring to FIGS. 8A and 8B, a gate trench GT and a connection trench CT may be formed.

The gate trenches GT may be formed by partially removing the source region 107, the well region 105, and the drift layer 102 using a mask layer. The connection trench CT may be formed by partially removing the drift layer 102. The drift layer 102 may be exposed through bottom surfaces of the gate trench GT and the connection trench CT. The gate trench GT and the connection trench CT may be formed together and may have substantially the same depth in the vertical direction.

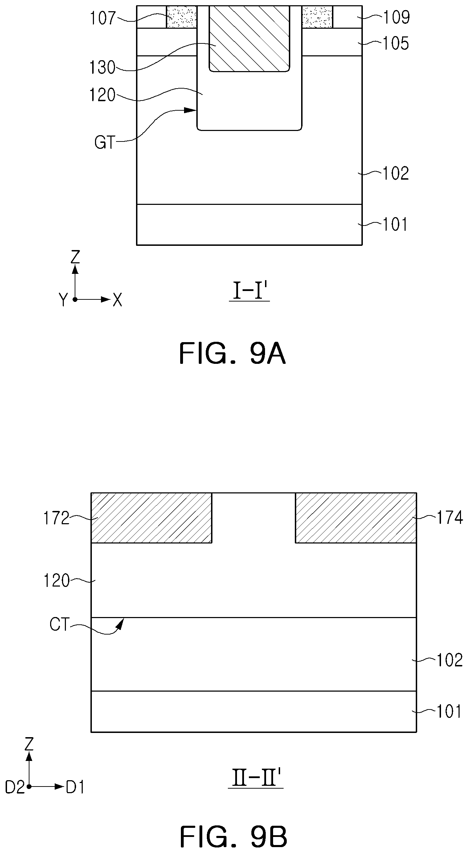

Referring to FIGS. 9A and 9B, a gate insulating layer 120, a gate electrode 130, a gate bus line 172, and a gate pad 174 may be formed.

First, the gate insulating layer 120 may be formed in both the gate trench GT and the connection trench CT. The gate insulating layer 120 may be formed by forming an insulating layer to fill the gate trench GT and the connection trench CT and partially removing the insulating layer. Alternatively, the gate insulating layer 120 may be formed by forming a uniform first insulating layer by an oxidation process, such as a thermal oxidation process, and further forming a second insulating layer on the first insulating layer by a spin-on glass (SOG) process, or a high temperature oxide (HTO) process. The gate insulating layer 120 may be formed thicker on bottom surfaces of the gate trench GT and the connection trench CT than on sidewalls of the gate trench GT and the connection trench CT.

Thereafter, a gate electrode 130 may be formed in the gate trench GT by depositing a conductive material, and a gate bus line 172 and a gate pad 174 may be formed in the connection trench CT. When the gate electrode 130, the gate bus line 172, and the gate pad 174 are formed together, the gate electrode 130, the gate bus line 172, and the gate pad 174 may include the same metal material.

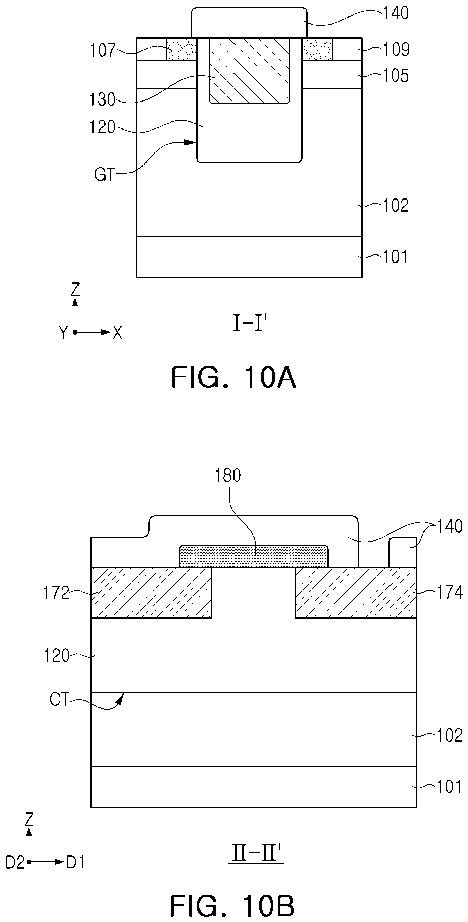

Referring to FIGS. 10A and 10B, a connector 180 may be formed and dielectric layers 140 may be formed.

The connector 180 may be formed on a portion of the gate bus line 172 and a portion of the gate pad 174 to connect the gate bus line 172 to the gate pad 174. The connector 180 may be formed by depositing and patterning a conductive material.

The dielectric layers 140 may be deposited on the entire upper surface of the structure being manufactured and partially removed to expose a portion of each of the source regions 107, the well contact regions 109, and the gate pad 174 by an etching process.

Thereafter, referring to FIGS. 2A and 2B together, a source electrode 150 and a pad metal layer 194 may be formed on the dielectric layers 140, and a drain electrode 160 may be formed on a lower surface of the substrate 101. In some example embodiments, the drain electrode 160 may be formed in other processes than processes to form for the source electrode 150 and the pad metal layer 194. Accordingly, the power semiconductor device 100 in FIGS. 2A and 2B may be manufactured.

According to the aforementioned example embodiments, by including a high-resistance connector connecting the gate bus line to the gate pad, a power semiconductor device having improved electrical properties may be provided.

While the example embodiments have been illustrated and described above, it will be configured as apparent to those skilled in the art that modifications and variations may be made without departing from the scope of the invention.

### Annex A

The present invention can also be defined by reference to the following clauses:
Clause 1. A power semiconductor device, comprising:
   a substrate having a first conductivity type;
   a drift layer having the first conductivity type on the substrate;
   a well region having a second conductivity type on the drift layer;
   source regions having the first conductivity type on the well region;
   gate insulating layers in gate trenches penetrating the source regions and the well region and extending in a first direction parallel to an upper surface of the substrate, and including a high-κ material;
   gate electrodes on the gate insulating layers in the gate trenches and including a metal material;
   a gate bus (BUS) line connected to ends of the gate electrodes and extending in a second direction intersecting the first direction;
   a gate pad spaced apart from the gate bus line;
   a connector electrically connecting the gate bus line to the gate pad and including a material having a resistivity greater than a resistivity of the gate bus line and the gate pad;
   a dielectric layer on the gate electrodes, the gate bus line, the gate pad, and the connector; and
   a drain electrode on a lower surface of the substrate.
Clause 2. The power semiconductor device of clause 1, wherein the gate bus line and the gate pad include a metal, and the connector includes polycrystalline silicon. Clause 3. The power semiconductor device of clause 1 or clause 2, wherein the gate bus line and the gate pad include a metal having a first resistivity, and the connector includes a metal having a second resistivity greater than the first resistivity.
Clause 4. The power semiconductor device of any of clauses 1 to clause 3, wherein the gate bus line and the gate pad are in a connection trench extending in the drift layer.
Clause 5. The power semiconductor device of clause 4, wherein the connector has a portion extending into the connection trench.
Clause 6. The power semiconductor device of any of clauses 1 to 5, wherein the connector is in contact with an upper surface of the gate bus line and an upper surface of the gate pad.
Clause 7. The power semiconductor device of any of clauses 1 to 6 , wherein the connector is in contact with a side surface of the gate bus line and a side surface of the gate pad.
Clause 8. The power semiconductor device of clause 7, wherein a lower surface of the connector is on a level lower than a level of upper surfaces of the source regions.
Clause 9. The power semiconductor device of clause 8, wherein an upper surface of the connector is on a level lower than the level of the upper surfaces of the source regions.
Clause 10. The power semiconductor device of any of clauses 1 to 9, wherein the connector includes a doped region having the second conductivity type in the drift layer.
Clause 11. The power semiconductor device of clause 10, further comprising:
   a bus metal layer on the dielectric layer and connected to the gate bus line and the connector; and
   a pad metal layer on the dielectric layer and connected to the gate pad and the connector.
Clause 12. The power semiconductor device of any of clauses 1 to 11, wherein each of the gate insulating layers has a first thickness on a bottom surface of each of the gate trenches, and a second thickness less than the first thickness on a sidewall of each of the gate trenches.
Clause 13. The power semiconductor device of any of clauses 1 to 12, further comprising:
   a source electrode on the dielectric layer and connected to the source regions.
Clause 14. The power semiconductor device of any of clauses 1 to 13, wherein the substrate, the drift layer, and the well region include SiC.
Clause 15. A power semiconductor device, comprising:
   a substrate having a first conductivity type;
   a drift layer having the first conductivity type on the substrate;
   a well region having a second conductivity type on the drift layer;
   source regions having the first conductivity type on the well region;
   gate insulating layers in gate trenches penetrating the source regions and the well region and extending in a first direction parallel to an upper surface of the substrate;
   gate electrodes on the gate insulating layers in the gate trenches;
   a gate bus line electrically connected to the gate electrodes;
   a gate pad spaced apart from the gate bus line;
   a connector electrically connecting the gate bus line to the gate pad; and
   a drain electrode on a lower surface of the substrate,
   wherein the gate electrodes include a material having a first resistivity, the gate bus line and the gate pad include a material having a second resistivity equal to or greater than the first resistivity, and the connector includes a material having a third resistivity greater than the second resistivity.
Clause 16. The power semiconductor device of clause 15,
   wherein the gate bus line includes a plurality of gate bus lines, and
   wherein the connector is configured as a single connector connecting the plurality of gate bus lines to the gate pad.
Clause 17. The power semiconductor device of clause 15 or clause 16,
   wherein the gate bus line includes a plurality of gate bus lines, and
   wherein the connector includes a plurality of connectors connecting each of the plurality of gate bus lines to the gate pad.
Clause 18. The power semiconductor device of any of clauses 15 to 17, wherein the connector includes a semiconductor material.
Clause 19. A power semiconductor device, comprising:
   a substrate having a first conductivity type;
   a drift layer having the first conductivity type on the substrate;
   a well region having a second conductivity type on the drift layer;
   source regions having the first conductivity type on the well region;
   gate insulating layers in gate trenches penetrating the source regions and the well region and extending in a first direction parallel to an upper surface of the substrate;
   gate electrodes on the gate insulating layers in the gate trenches;
   a gate bus line connected to ends of the gate electrodes and extending in a second direction perpendicular to the first direction;
   a gate pad spaced apart from the gate bus line;
   a connector electrically connecting the gate bus line to the gate pad and including a material having a resistivity greater than a resistivity of the gate bus line and the gate pad; and
   a drain electrode on a lower surface of the substrate,
   wherein each of the gate insulating layers has a first thickness on a bottom surface of each of the gate trenches, and has a second thickness less than the first thickness on a sidewall of each of the gate trenches.
Clause 20. The power semiconductor device of clause 19,
   wherein the gate electrodes have a first width in the second direction,
   wherein the gate bus line has a second width greater than the first width in the first direction, and
   wherein the gate pad has a third width greater than the second width in the second direction.

## Claims

1. A power semiconductor device, comprising:
a substrate having a first conductivity type, the substrate being provided with a drift layer having the first conductivity type on the substrate;
a well region having a second conductivity type on the drift layer;
source regions having the first conductivity type on the well region;
gate insulating layers in gate trenches, the gate insulating layers penetrating the source regions and the well region and extending in a first direction parallel to an upper surface of the substrate, and including a high-x material;
gate electrodes on the gate insulating layers in the gate trenches and including a metal material;
a gate bus line connected to ends of the gate electrodes and extending in a second direction intersecting the first direction;
a gate pad spaced apart from the gate bus line;
a connector electrically connecting the gate bus line to the gate pad, the connector having resistivity greater than those of the gate bus line and the gate pad;
a dielectric layer on the gate electrodes, the gate bus line, the gate pad, and the connector; and
a drain electrode on a lower surface of the substrate.

2. The power semiconductor device of claim 1, wherein the gate bus line and the gate pad include a metal, and the connector includes polycrystalline silicon.

3. The power semiconductor device of claim 1, wherein the gate bus line and the gate pad include a metal having first resistivity, and the connector includes a metal having second resistivity greater than the first resistivity.

4. The power semiconductor device of any preceding claim, wherein the gate bus line and the gate pad are in a connection trench, and the connection trench extends into the drift layer.

5. The power semiconductor device of claim 4, wherein the connector has a portion extending into the connection trench.

6. The power semiconductor device of any preceding claim, wherein the connector is in contact with an upper surface of the gate bus line and an upper surface of the gate pad.

7. The power semiconductor device of any preceding claim, wherein the connector is in contact with a side surface of the gate bus line and a side surface of the gate pad.

8. The power semiconductor device of claim 7, wherein a lower surface of the connector is at a level lower than a level of upper surfaces of the source regions.

9. The power semiconductor device of claim 8, wherein an upper surface of the connector is at a level lower than the level of the upper surfaces of the source regions.

10. The power semiconductor device of any preceding claim, wherein the connector includes a doped region having the second conductivity type in the drift layer.

11. The power semiconductor device of claim 10, further comprising:
a bus metal layer on the dielectric layer and connected to the gate bus line and the connector; and
a pad metal layer on the dielectric layer and connected to the gate pad and the connector.

12. The power semiconductor device of any preceding claim, wherein each of the gate insulating layers has a first thickness on a bottom surface of each of the gate trenches and a second thickness on a sidewall of each of the gate trenches, and the second thickness is less than the first thickness.

13. The power semiconductor device of any preceding claim, further comprising:
a source electrode on the dielectric layer and connected to the source regions.

14. The power semiconductor device of any preceding claim, wherein the substrate, the drift layer, and the well region include SiC.
